Europäisches Patentamt

European Patent Office

Office européen des brevets

(19)

(11) Veröffentlichungsnummer: **0 130 457**
**A1**

(12) # EUROPÄISCHE PATENTANMELDUNG

(21) Anmeldenummer: **84106988.3**

(22) Anmeldetag: **19.06.84**

(51) Int. Cl.⁴: **H 01 L 21/265, H 01 L 29/32**

(30) Priorität: **01.07.83 DE 3323672**

(43) Veröffentlichungstag der Anmeldung: **09.01.85**
**Patentblatt 85/2**

(84) Benannte Vertragsstaaten: **AT BE CH DE FR GB IT LI LU NL SE**

(71) Anmelder: **Hahn-Meitner-Institut für Kernforschung Berlin GmbH, Glienicker Strasse 100, D-1000 Berlin 39 (DE)**
Anmelder: **BROWN, BOVERI & CIE Aktiengesellschaft, Kallstadter Strasse 1, D-6800 Mannheim 31 (DE)**

(72) Erfinder: **Fahrner, Wolfgang, Dr. Dipl.-Phys., Glienicker Strasse 66, D-1000 Berlin 39 (DE)**
Erfinder: **Bräunig, Dietrich, Dr. Dipl.-Ing., Fransbader Strasse 14, D-1000 Berlin 33 (DE)**
Erfinder: **Knoll, Meinhard, Dr. Dipl.-Ing., Gasteiner Strasse 13, D-1000 Berlin 31 (DE)**
Erfinder: **Neidig, Arno, Dr. Dipl.-Phys., Brühlerweg 42, D-6831 Plankstadt (DE)**

(74) Vertreter: **Kempe, Wolfgang, Dr. et al, c/o Brown, Boveri & Cie AG Postfach 351, D-6800 Mannheim 1 (DE)**

(54) **Halbleiter-Bauelement mit mindestens einem pn-Übergang und mit in der Tiefe der Basisschicht scharf lokalisierten Ionen, Verfahren zu dessen Herstellung und seine Verwendung.**

(57) Bei Halbleiter-Leistungs-Bauelementen – Dioden, Transistoren, Thyristoren – ist die Sperrverzögerungs-, Abschalt- bzw. Freiwerdezeit für die Frequenzgrenze bestimmend. Bei einer Verminderung der Freiwerdezeit sollen aber andere maßgebliche Parameter – Stromverstärkung, Leckstrom, Vorwärtsspannungsabfall – möglichst nicht beeinträchtigt werden.

Dies wird mit in der Tiefe der Basisschicht scharf lokalisiert implantierten Ionen erreicht, die chemisch und/oder elektrisch aktiv sind und beliebiges Atomgewicht haben können. Es entstehen reine oder assoziierte intrinsische und extrinsische Defekte in einer Zone mit Ladungsträgern geringer Lebensdauer. Nach der Implantation wird das Bauelement durch eine Temperung stabilisiert.

HAHN-MEITNER-INSTITUT FÜR KERNFORSCHUNG BERLIN GMBH

und

BROWN, BOVERI & CIE AKTIENGESELLSCHAFT

61/0783

Halbleiter-Bauelement mit mindestens einem pn-Übergang und mit in der Tiefe der Basisschicht scharf lokalisierten Ionen, Verfahren zu dessen Herstellung und seine Verwendung

Die Erfindung betrifft das Gebiet der Halbleiter-Bauelemente mit mindestens einem pn-Übergang und mit in der Tiefe der Basisschicht scharf lokalisierten Ionen; sie bezieht sich auf ein solches Bauelement, ein besonders angepaßtes Verfahren zu dessen Herstellung und auf seine Verwendung.

Bei Halbleiter-Leistungsbauelementen - Dioden, Transistoren, Vierschichtstrukturen - ist die Sperrverzögerungs-, Abschalt- bzw. Freiwerdezeit für die Frequenzgrenze des Bauelementes bestimmend. Dementsprechend ist man bestrebt, diese Zeit möglichst zu verkürzen. Dabei hat es sich gezeigt, daß eine Verminderung der Freiwerdezeit mit herkömmlichen Mitteln stets eine Beeinträchtigung anderer maßgeblicher Parameter mit sich führt, nämlich der Stromverstärkung, des Leckstromes und des Vorwärtsspannungsabfalls.

Wie z. B. aus der US-PS 3943 549 und der US-PS 3877 997 bekannt ist, wird die Freiwerdezeit eines Thyristors durch die Minoritätsträgerlebensdauern und damit durch die Zahl der Rekombinationszentren der Basis bestimmt. Die Einbringung dieser Zentren erfolgt z. B. durch Diffusion von Materialien, die tiefe Zentren erzeugen, z. B. Gold, Platin, Nickel, oder durch Bestrahlung mit Elektronen bzw. mit $\gamma^-$ oder Röntgenquanten. Dadurch werden Generations-Rekombinationszentren erzeugt, die - von vernachlässigbaren Abweichungen abgesehen - homogen, insbesondere über die Dicke einer Schicht im Bauelement gleichmäßig verteilt sind. Diese Zentren sind charakterisiert durch ihre Dichte $N_T$, dim $N_T = cm^{-3}$, ihr Energieniveau im verbotenen Band $E_T$, dim $E_T$ = eV, und ihre Einfangkonstanten für Elektronen, $c_n$, und für Löcher $c_p$, dim $c_{n,p} = cm^{-3} \cdot s^{-1}$. Durch diese Größen werden drei wichtige Kennwerte eines Thyristors bestimmt, nämlich Leckstrom $I_R$, Freiwerdezeit $\tau_q$ und Vorwärtsspannungsabfall $U_T$. Es gilt nämlich:

$$(1) \quad \tau_{SC} = \tau_p \cdot \exp\left(\frac{E_T - E_i}{kT}\right) + \tau_n \cdot \exp\left(\frac{E_i - E_T}{kT}\right)$$

$$(2) \quad \tau_{LI} = \tau_p \left[1 + \exp\left(\frac{E_T - E_F}{kT}\right)\right] + \tau_n \cdot \exp\left(\frac{E_i - E_T}{kT} + \frac{E_i - E_F}{kT}\right)$$

$$(3) \quad \tau_{HI} = \tau_p + \tau_n$$

In den Formeln (1) und (2) ist $E_i$ die Eigenleit-Fermi-Energie, dim $E_i$ = eV, und $E_F$ die Fermi-Energie des Siliziums, dim $E_F$ = eV. In Formel (3) sind die Produkte $N_T \cdot c_n = \tau_n^{-1}$ und $N_T c_p = \tau_p^{-1}$ eingeführt worden.

Der Leckstrom, $I_R$, dim $I_R$ = A, leitet sich dann aus der Generationslebensdauer $\tau_{SC}$ ab über

$$(4) \quad I_R = q \cdot n_i \cdot A \cdot W / \tau_{SC}$$

In Formel (4) sind:

$q$: die Elementarladung, dim $q$ = As

$n_i$: die Eigenleitdichte des Siliziums,
dim $n_i$ = cm$^{-3}$

$A$: die Fläche des Querschnitts, dim$A$ = cm$^2$

$W$: die Raumladungstiefe, dim$W$ = cm

Für die Freiwerdezeit $\tau_q$ (gemessen bei 125 $^\circ$C) gilt ein genäherter Zusammenhang mit der Niedriginjektionslebensdauer $\tau_{LI}$:

$$(5) \quad \tau_q \, (125 \, ^\circ C) = 8 \, \tau_{LI} \, (25 \, ^\circ C)$$

Der Vorwärtsspannungsabfall $U_T$ schließlich ermittelt sich aus der Vorwärtskennlinie des Thyristors:

$$(6) \quad I = A \, \frac{q \, n_i \, w}{\tau_{HI}} \quad (e^{Uq/kT} - 1).$$

In Formel (6) bedeuten:

$w$ = Länge der Basis, dim $w$ = cm

$U$ = Vorwärtsspannungsabfall, dim $U$ = V

$k$ = Boltzmannkonstante

$T$ = Temperatur, dim $T$ = K

Daraus ist folgendes zu erkennen: Über eine Erhöhung der Zahl der Generations-Rekombinationszentren $N_T$ werden die Minoritätsträgerlebensdauern $\tau_n = (c_n \cdot N_T)^{-1}$ und $\tau_p = (c_p \cdot N_T)^{-1}$ abgesenkt und damit nach Gleichung (2) eine Absenkung der Niedrig-Injektionslebensdauer $\tau_{LI}$ bzw. nach Gleichung (5) die gewünschte Absenkung der Freiwerdezeit $\tau_q$ erreicht. Gleichungen (1) und (3) zeigen aber, daß parallel dazu eine Absenkung der Generationslebensdauer $\tau_{SC}$ und der Hochinjektionszeitkonstanten $\tau_{HI}$ erzwungen wird. Nach Gleichungen (4) und (6) bedeutet das einen Anstieg der Leckströme und des Vorwärtsspannungsabfalls über die Spezifikationen des Bauelementes hinaus. Eine Verringerung der Freiwerdezeit unter Beibehaltung der Bedingung von "homogener" Bestrahlung kann nur über die Exponentialterme der Gleichungen (1), (2) und (3) erreicht werden. Nach einer Abschätzung resultieren für den Bereich technischer Anwendungen die Forderungen $\tau_n \geq 100$ µs und $\tau_p \leq 0,5$ µs. Ferner muß $E_T \approx E_i$ sein oder $E_T \approx E_F$. Untersuchungen, ob es Zentren gibt, die diese extremen Anforderungen erfüllen, haben zumindest zu keinem befriedigendem experimentellen Ergebnis geführt.

Eine grundsätzlich andere Lösung ist aus der US-PS 4 311 534 bekannt. Danach führt eine senkrecht auf das Bauelement gerichtete Bestrahlung mit Stickstoff-Ionen, α-Teilchen oder Protonen im Energiebereich $E \leq 10$ MeV zur Erzeugung von in der Tiefe scharf lokalisierten Rekombinationszentren in der Raumladungszone des Anodenn⁻-Basisübergangs. Auf die Verwendung von Ionen größerer Massen (Molekulargewicht größer 16) sei noch aus technischen Gründen solange zu verzichten, wie keine Beschleuniger verfügbar sind, mit denen sich die nötigen Eindringtiefen erreichen lassen. Ionen mit elektrischer und chemischer Aktivität sollen nach der Lehre dieses bekannten Standes der Technik auf jeden Fall ausgeschlossen sein (vgl. a. a. O. , Spalte 4, Zeilen 7 bis 30).

Der Erfindung liegt die Aufgabenstellung zugrunde, solche Maßnahmen aufzuzeigen, die eine Verkürzung der Schalt- bzw. Freiwerdezeit bei Halbleiter-Bauelementen bewirken, ohne jedoch gleichzeitig andere maßgebliche Parameter zu beeinträchtigen. Gemäß der Erfindung wird dies bei einem Bauelement der eingangs genannten Art gelöst durch implantierte chemisch und/oder elektrisch aktive Ionen beliebigen Atomgewichts als Rekombinations-Generationszentren für intrinsische und extrinsische Defekte. Bei besonders vorteilhaften Ausführungsformen der Erfindung handelt es sich um in eine $n^-$-Basis implantierte Ionen.

Von wesentlicher Bedeutung für die Erfindung ist, daß auch extrinsische Defekte und Assoziate, insbesondere Mischformen extrinsischer und intrinsischer Defekte zur Anwendung kommen können und daß Bauelemente, die zunächst ohne Anwendung der erfindungsgemäßen Maßnahmen hergestellt worden sind, sich nachträglich zumindest noch etwas verbessern lassen. Würde man sich - wie z. B. der o. g. US-PS 4 311 534 mehrfach und eindringlich zu entnehmen ist - auf chemisch und elektrisch inaktive Ionen beschränken, könnten nur intrinsische Defekte als Rekombinationszentren erzeugt werden. Damit wäre der Bereich anwendbarer tiefer Energielagen im verbotenen Band des halbleitenden Materials, z. B. des Siliziums, und der Einfanggrößen erheblich eingeschränkt.

Der Vorteil der Erfindung liegt - bei nicht bereits anderweitig behandelten Bauelementen - insbesondere darin, daß im Parameter-Tripel: "Freiwerdezeit/Vorwärtsspannungsabfall/Leckstrom bzw. Sperrstrom" jede dieser Größen weitgehend unabhängig von den anderen optimiert werden kann, d. h. mit anderen Worten, eine Verminderung der Freiwerdezeit ist nicht mehr unumgänglich mit einer Inkaufnahme von Verschlechterungen anderer Parameter verbunden. Derartige Optimierungen müssen also selbstverständlich bereits bei der Herstellung eines solchen Halbleiter-Bauelements vorgenommen werden. Gemäß der Erfindung ist ein hierauf besonders angepaßtes Herstellungsverfahren gekennzeichnet durch eine Implantation chemisch und/oder elektrisch aktiver Ionen mit einer in Abhängigkeit von der Ionensorte, der Eindringtiefe und dem Implantationsprofil zu wählenden Energie durch senkrecht auf das Bauelement gerichtete Bestrahlung und eine nachfolgende Temperung des Bauelements bei einer Temperatur von mindestens 450 $^{\circ}$C, maximal 900 $^{\circ}$C, für die Dauer von mindestens 10, vorzugsweise 30 Minuten. Der Ionenstrahl kann auch durch eine Lochblende seitlich begrenzt werden. Eine über die Mindest- bzw. optimale Dauer der Temperung hinausgehende Temperung ist unkritisch. Die Temperung kann vorteilhaft auch in sehr viel kürzerer Zeit als schnelle Temperung mittels Laser- und/oder Elektronenstrahlen erfolgen.

Da bei inzwischen verfügbaren Ionenbeschleunigern die Energie in weiten Bereichen frei wählbar ist, bestehen praktisch keine Beschränkungen in der Wahl der Ionensorte und -Dosis, der gewünschten Eindringtiefe, d. h. der mittleren Lage des Ionenimplantationsprofils innerhalb der $n^-$-Basis, und des Profils als solchem. Hierfür sind Halbwertsbreiten - wie an sich bekannt - von etwa 20 μm erzielbar. Die Dosis sollte etwa $10^{12}$ Ionen/cm$^2$ nicht überschreiten. Die nachfolgende Temperung des Bauelements hat wesentlichen Einfluß auf seine späteren Betriebseigenschaften. Insbesondere wird hierdurch die sonst auftretende Selbstheilung intrinsischer Rekombinationszentren verhindert. Es erfolgt vielmehr eine elektrische Aktivierung dotierender Ionen. Sie werden in die Gitterstruktur des Siliziums fest eingebaut und wirken sich damit wie eine Grunddotierung auf die Schaltzeiteigenschaften aus.

Für Ausführungsformen des erfindungsgemäßen Herstellungsverfahrens sind also folgende Maßnahmen wesentlich:

- Es werden chemisch und/oder elektrisch aktive Ionen mit einem Ionenbeschleuniger mit oder ohne seitliche(r) Begrenzung, in jedem Fall aber in der Tiefe scharf lokalisiert in die $n^-$-Basis des Bauelementes implantiert und dadurch reine oder assoziierte intrinsische und extrinsische Defekte erzeugt.

- Nach der Ionen-Implantation wird das Bauelement durch eine Temperung stabilisiert.

Mit der ersten Maßnahme werden die beiden Vorteile einer engen Lokalisierung der Defektzentren einerseits und der optimalen Wahl von Energieniveau bzw. Einfangwahrscheinlichkeit des eingebrachten Rekombinationszentrums andererseits vereinigt. Die zweite Maßnahme bewirkt die Langzeitstabilisierung des Bauelementes. Die Implantation kann z. B. mittels eines Ionenbeschleunigers mit einer Endenergie oberhalb 10 MeV und hinreichender Stromstärke erfolgen.

Die Wahl von Ionenenergie, -dosis und -sorte bzw. der Temperungstemperatur, -dauer und -gase erfolgt empirisch. Dazu werden bei festgehaltener Energie Vorwärtsspannung, Freiwerdezeit (oder Sperrverzögerungsladung) und Leckstrom als Funktion der implantierten Dosis gemessen. Die Messung wird wiederholt für den Bereich der Energie, die zu einer Defektmaximumslage zwischen

- S -

0130457

p-Basis und dem anodenseitigen p-n-Übergangsbereich führt. Anschließend werden die Bauelemente während einer festen Zeitdauer von etwa 30 min und in einem Ausheilgas (z. B. Formiergas, Wasserstoff) verschiedenen Temperaturen unterworfen, etwa im Bereich von 400 °C bis 900 °C.

Die Schalt- bzw. Freiwerdezeit wurde bei Ausführungsformen der Erfindung um mindestens den Faktor 2 reduziert. Gemäß der Erfindung finden solche Halbleiter-Bauelemente deshalb vorzugsweise Verwendung als schnelle Leistungsdiode, als Leistungstransistor oder auch als schneller Frequenz -Thyristor.

Über die Eigenschaften eines entsprechenden Thyristors wurde im Rahmen der "12$^{th}$ Europ. Solid State Device Research Conf." ESSDERC 82, zusammen mit "1982 7$^{th}$ Symp. on Solid State Device Technology" München, 13./16. Sept. 1982, s. a. Tagungsunterlagen S. 121/122 berichtet.

Ausführungsformen der Erfindung werden nachfolgend anhand der Zeichnungen noch näher erläutert. Dabei zeigen:

    Fig. 1: einen vereinfachten Querschnitt durch einen Thyristor,

    Fig. 2: eine Seitenansicht, teilweise geschnitten, für die Anordnung eines zu bestrahlenden Bauelements

    Fig. 3: einen vereinfachten Querschnitt durch einen Thyristor mit Angabe der Lage und des Profils implantierter Ionen,

Fig. 4: ein Schaubild für ein Borprofil in Silizium und Fig. 5 und 6: Schaubilder für die zeitliche Änderung der Ladungsträger-Konzentration in einem Bauelement ohne - Fig. 5 - und mit - Fig. 6 - Ionenimplantation.

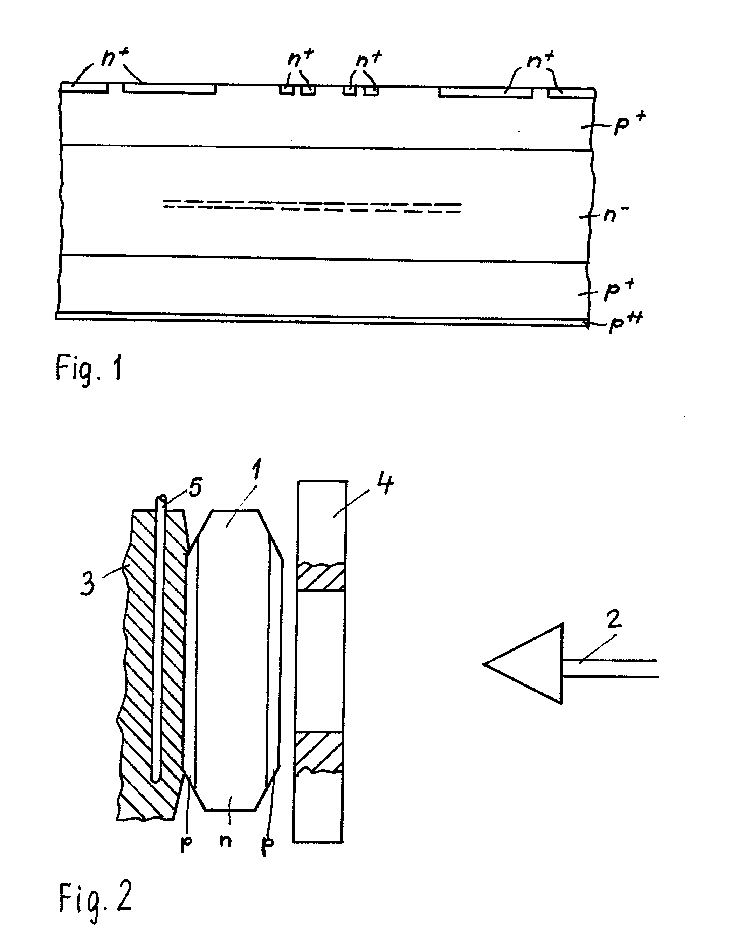

Die Fig. 1 zeigt ein typisches Beispiel für einen Thyristor während seiner Herstellung, d. h. in einem Stadium, in dem bereits alle Schichten hergestellt und Dotierungsschritte durchgeführt , jedoch noch keine Metallisierungen, Anschlüsse, Abdeckungen oder Passivierungen vorhanden sind. Nachdem dieses Bauelement dem Ionenstrahl eines Hochenergie-Ionenbeschleunigers ausgesetzt worden ist (s. a. Fig. 2), befinden sich in der $n^-$-Basis in dem durch Strichelung angegebenen Bereich in der Tiefe scharf lokalisierte Ionen, durch die eine Zone mit geringer Ladungsträger-Lebensdauer im Bauelement entstanden ist.

Wie der Fig. 2 zu entnehmen ist, gelangen in einem Strahl 2, der im wesentlichen senkrecht zur Oberfläche des Bauelements 1, z. B. eines Thyristors, gerichtet ist, Ionen in das Bauelement 1. Es können mehrere derartige Bauelemente 1 auf einem Karussel 3 montiert sein oder z. B. auch über einen Kassettenwechsler an den Bestrahlungsort gebracht werden. Die Halterung für die Bauelemente 1 sollte vorteilhaft heizbar oder kühlbar sein. Als Ausführungsbeispiel hierfür ist ein Teil einer Rohrschlange 5 dargestellt, in der ein Kühlmittel zirkuliert, sich eine Heizspirale befindet oder dgl. Die optimale Temperatur während der Bestrahlung ist empirisch zu ermitteln.

Teile des zu bestrahlenden Bauelements 1, insbesondere z. B. dessen Randbereiche, können mittels einer hinreichend dicken Lochblende 4, z. B. aus Silizium, Aluminium oder ähnlichem Material, abgedeckt werden. Die Blende 4 wird beispielsweise an -1 kV Spannung gelegt. Der Ionenstrahl 2 kann dem Bauelement 1 fokussiert oder auch gewedelt zugeführt werden. Die Ionendosis wird, nachdem die Ionensorte ausgewählt und festgelegt worden ist, durch Integration des Strahlstromes unter Berücksichtigung von Blendenfläche, Bestrahlungszeit und Ionenladungszustand ermittelt.

Die Temperung bestrahlter Bauelemente 1 kann beispielsweise sofort nach der Bestrahlung erfolgen. Dies kann bei einem Karussel 3 , einem Kassettenwechsler usw. in einer der nächsten Stellungen erfolgen bzw. beginnen oder aber auch in einer Prozeßeinheit mit der Metallsinterung bzw. anderen Hochtemperaturprozessen erfolgen, dem die Bauelemente 1 zu unterziehen sind, soweit deren Prozeßbedingungen mit denen der Temperung nach der Ionenimplantation kompatibel sind.

Anschließend werden die Bauelemente 1 nach Standardverfahren fertiggestellt.

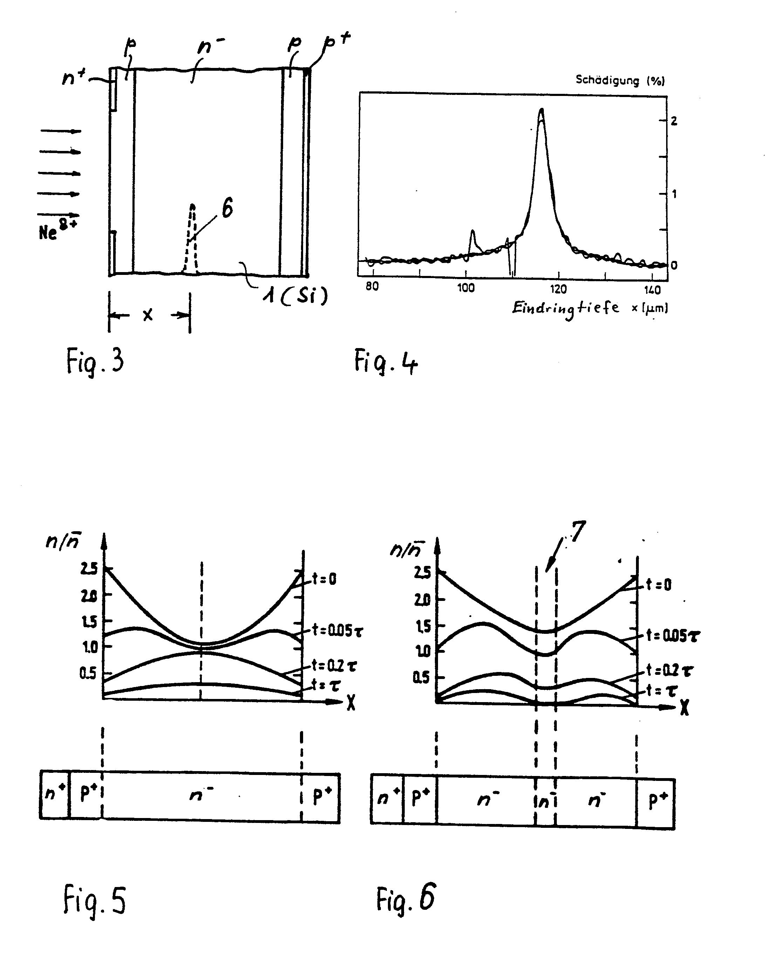

Für das in Fig. 3 gezeigte Bauelement 1, einen Thyristor, ist in dessen $n^-$-Basis das Profil 6 der dort in der Tiefe x senkrecht zur Bestrahlungsrichtung eingedrungenen scharf lokalisiert implantierten Ionen angegeben. Beiderseits des Maximums sinkt die Konzentration sehr schnell auf meßtechnisch nicht mehr erfaßbare Werte. Der absolute Wert der Tiefe x ist frei wählbar. Das bedeutet, daß sich im Prinzip dieses Bild unabhängig vom Halbleitermaterial und der gewählten Ionensorte ergibt.

Das Ionenprofil und dessen Lage in einem Bauelement lassen sich als "Schädigung" des Halbleitermaterials infolge der dort implantierten Ionen auffassen.

In Fig. 4 ist in einem Schaubild das Borprofil in Silizium nach einer 56 MeV-Implantation ohne Nachtemperung dargestellt. Gemessen wurde an drei verschiedenen Stellen der Silizium-Scheibe. 100 % Schädigung entspricht dem Auftreten von "amorphen Ringen" in der Elektronenbeugung. Da die Eindringtiefe x abhängig von der Energie des Beschleunigers und den Massen der Ionen und des Grundmaterials ist, kann das Ionenprofil dementsprechend gewählt werden. Halbwertsbreiten der Ionenprofile von ca. 20 μm für eine derart scharfe Lokalisierung sind üblich.

Durch Vergleich der in den Fig. 5 und 6 gezeigten Schaubilder, in denen zu jeweils vier diskreten Zeitpunkten t der Verlauf der Ladungsträgerkonzentration $n/\bar{n}$ über der Dicke x der Basisschicht angegeben ist, wobei Fig. 5 für ein Bauelement ohne, Fig. 6 für ein Bauelement mit implantierten Ionen gilt (vergleiche auch die unter den betreffenden Schaubildern angegebenen Schichtenfolgen), ist die Wirkungsweise bezüglich der Erhöhung der Schaltgeschwindigkeit durch eine Zone 7 von Ladungsträgern mit geringer Lebensdauer in der Basisschicht deutlich zu erkennen. Diese Zone 7, die sehr dünn ist und sich senkrecht zur Stromflußrichtung erstreckt, führt anfänglich - bei t = 0 und t = 0,05 τ - zu einer geringfügigen Erhöhung der Kon-

0130457

zentration der Ladungsträger im Vergleich zu einem Bauelement ohne eine solche Zone, bereits nach kurzer Zeit - bei $t = 0,2\,\tau$ - jedoch schon zu bemerkenswert geringeren Werten, besonders an den Grenzen zu den benachbarten $p^{+}$-Schichten. Zum Zeitpunkt $t = \tau$, zu dem bei einem Bauelement mit einer Zone 7 von Ladungsträgern geringer Lebensdauer ein neuer Schaltzyklus beginnen könnte, ist hingegen bei einem Bauelement ohne eine solche Zone noch eine beachtliche Ladungsträgerkonzentration vorhanden. Über diese Erscheinungen, allerdings noch als theoretisches Ergebnis entsprechender Berechnungen, wird übrigens auch in "IEEE Transactions on Electron Devices" Vol. ED-30, Nr. 7 (Juli 1983), Seiten 782 bis 790 berichtet.

0130457

- 1 -

HAHN-MEITNER-INSTITUT FÜR KERNFORSCHUNG BERLIN GMBH
und

BROWN, BOVERI & CIE AKTIENGESELLSCHAFT

61/0783

Patentansprüche

1. Halbleiter-Bauelement mit mindestens einem pn-Übergang und mit in der Tiefe der Basisschicht scharf lokalisierten Ionen,
gekennzeichnet durch
implantierte, chemisch und/oder elektrisch aktive Ionen beliebigen Atomgewichts als Rekombinations-Generations-Zentren für intrinsische und extrinsische Defekte.

2. Halbleiter-Bauelement nach Anspruch 1,
gekennzeichnet durch in eine $n^-$-Basis implantierte Ionen.

3. Verfahren zur Herstellung eines Halbleiter-Bauelements nach Anspruch 1 oder 2,
dadurch gekennzeichnet, daß
eine Implantation chemisch und/oder elektrisch aktiver Ionen mit einer in Abhängigkeit von der Ionensorte, der Eindringtiefe und dem Implantationsprofil zu wählenden Energie durch senkrecht auf das Bauelement gerichtete Bestrahlung und nachfolgend eine Temperung des Bauelements bei einer Temperatur von mindestens 400 $^{\circ}$C, maximal 900 $^{\circ}$C, für die Dauer von mindestens 10, vorzugsweise 30 Minuten durchgeführt wird.

4. Verfahren nach Anspruch 3,
dadurch gekennzeichnet, daß
der Ionenstrahl mittels einer Lochblende seitlich begrenzt wird.

0130457

5. Verfahren nach Anspruch 3 oder 4,
gekennzeichnet durch
eine schnelle Temperung mittels Laser- und/oder Elektronenbestrahlung.

6. Verwendung eines Halbleiter-Bauelements nach Anspruch 1 oder 2 als Leistungsdiode.

7. Verwendung eines Halbleiter-Bauelements nach Anspruch 1 oder 2 als Leistungstransistor.

8. Verwendung eines Halbleiter-Bauelements nach Anspruch 1 oder 2 als Thyristor.

Fig. 1

Fig. 2

$Ne^{8+}$

$n^+$ $p$ $n^-$ $p$ $p^+$

6

$1 \, (Si)$

$x$

**Fig. 3**

Schädigung (%)

80    100    120    140

*Eindringtiefe* $x \, [\mu m]$

**Fig. 4**

$n/\bar{n}$

2.5
2.0
1.5
1.0
0.5

$t=0$
$t=0.05\tau$
$t=0.2\tau$
$t=\tau$

$x$

$n^+$ $P^+$ $n^-$ $P^+$

**Fig. 5**

$n/\bar{n}$

7

2.5
2.0
1.5
1.0
0.5

$t=0$
$t=0.05\tau$
$t=0.2\tau$
$t=\tau$

$x$

$n^+$ $P^+$ $n^-$ $n^-$ $n^-$ $P^+$

**Fig. 6**

Europäisches
Patentamt

**EUROPÄISCHER RECHERCHENBERICHT**

0130457
Nummer der Anmeldung

EP 84 10 6988

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | US-A-4 151 540 (W.B. SANDER et al.) <br> * Spalte 2, Zeilen 24-53; Figuren 1,2 * | 1,2,7 | H 01 L 21/265 <br> H 01 L 29/32 |
| | --- | | |
| A | US-A-4 203 780 (T. MATSUSHITA et al.) <br> * Spalte 1, Zeile 9 - Spalte 4, Zeile 25; Figur 1 * | 1-3,6-8 | |
| | --- | | |
| A | DE-A-3 117 202 (BBC) <br> * Ansprüche 1,3,5; Figur 4 * | 1-3,8 | |
| | --- | | |
| A | US-A-4 318 750 (P. RAI-CHOUDHURY et al.) <br> * Spalte 3, Zeilen 10-15; Spalte 4, Zeilen 14-38; Spalte 5, Zeilen 28-48; Figuren 3,4,7 * | 1,3,4, 6-8 | RECHERCHIERTE SACHGEBIETE (Int. Cl. ³) |
| | --- | | |
| A | US-A-4 338 616 (I. BOL) <br> * Spalte 1, Zeile 53 - Spalte 2, Zeile 11; Spalte 2, Zeile 57 - Spalte 3, Zeile 12; Spalte 4, Zeile 64 - Spalte 5, Zeile 9; Spalte 5, Zeile 46 - Spalte 6, Zeile 5; Figur 1 * | 1,5 | H 01 L 21/00 <br> H 01 L 29/32 |
| | ---           -/- | | |

Der vorliegende Recherchenbericht wurde für alle Patentansprüche erstellt.

| Recherchenort | Abschlußdatum der Recherche | Prüfer |
|---|---|---|
| BERLIN | 29-08-1984 | ROUSSEL A T |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein-stimmendes Dokument

EPA Form 1503. 03.82

Europäisches Patentamt

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | GB-A-2 079 051 (WESTINGHOUSE)<br><br>* Seite 1, Zeile 62 - Seite 2, Zeile 22; Seite 3, Zeilen 6-19; Seite 4, Zeilen 14-19; Figuren 1,3 * & US-A-4 311 534 (Kat. D,A)<br><br>--- | 1,3,6-8 | |
| A | APPLIED PHYSICS LETTERS, Band 41, Nr. 8, October 1982, New York, USA; S.S. GILL "Multiply scanned electron beam annealing of ion implanted indium phosphide" Seiten 729-731<br>* ganzes Dokument *<br><br>----- | 5 | |

RECHERCHIERTE SACHGEBIETE (Int. Cl. ³)

*Der vorliegende Recherchenbericht wurde für alle Patentansprüche erstellt.*

| Recherchenort | Abschlußdatum der Recherche | Prüfer |
|---|---|---|
| BERLIN | 29-08-1984 | ROUSSEL A T |